(19) Europäisches Patentamt
European Patent Office
Office européen des brevets

(11) **EP 2 057 658 B1**

(12) **EUROPÄISCHE PATENTSCHRIFT**

(45) Veröffentlichungstag und Bekanntmachung des Hinweises auf die Patenterteilung:
**29.09.2010 Patentblatt 2010/39**

(21) Anmeldenummer: **07785695.3**

(22) Anmeldetag: **04.08.2007**

(51) Int Cl.:
**H01H 47/00** *(2006.01)* **G01R 15/20** *(2006.01)*

(86) Internationale Anmeldenummer:
**PCT/DE2007/001394**

(87) Internationale Veröffentlichungsnummer:
**WO 2008/025319 (06.03.2008 Gazette 2008/10)**

(54) **ANSCHLUSSEINHEIT EINES BUSSYSTEMS**

TERMINAL UNIT OF A BUS SYSTEM

UNITÉ DE CONNEXION D'UN SYSTÈME DE BUS

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **30.08.2006 DE 202006013311 U**

(43) Veröffentlichungstag der Anmeldung:
**13.05.2009 Patentblatt 2009/20**

(73) Patentinhaber: **Merten GmbH & Co. KG**
**51674 Wiehl (DE)**

(72) Erfinder:
• **KRAPEK, Pavel**
**68725 Hluk (CZ)**
• **PROCHOVNIK, Stepan**
**61400 Brno (CZ)**

(56) Entgegenhaltungen:
**EP-A- 1 865 331** **DE-A1- 10 045 563**
**DE-A1- 10 045 670** **DE-A1- 19 741 417**

**Beschreibung**

Die Erfindung betrifft eine Anschlusseinheit eines Bussystems, mit einem Mikroprozessor zur Erzeugung eines Aktor-Befehlssignals, einem durch das Aktor-Befehlssignal gesteuerten Schaltorgan zum Schalten einer eine Last einhaltende Versorgungsleitung und einem magnetisch sensitiven Stromsensor zur Detektierung bzw. Messung des Stromes in der Versorgungsleitung.

In der Gebäudesystemtechnik werden Bussysteme eingesetzt, die verteilt im Gebäude angeordnete Anschlusseinheiten aufweisen, welche entweder einen Sensor und/oder einen Aktor enthalten. Die Anschlusseinheiten können miteinander über Datentelegramme kommunizieren, wobei ein Sensor einen bestimmten Aktor oder mehrere Aktoren steuern kann. Bei dem Aktor kann es sich beispielsweise um ein Schaltorgan zum Schalten eines Verbrauchers, z. B. einer Leuchte, handeln.

Normalerweise erfolgt bei einem Bussystem keine Rückmeldung über die erfolgte Ausführung des Befehls. Wenn beispielsweise die zu schaltende Leuchte defekt ist und auf ein entsprechendes Aktor-Befehlssignal hin diese Leuchte zwar eingeschaltet wird, aber nicht leuchtet, wird dies von dem System nicht entdeckt und es erfolgt auch keine Fehlermeldung.

Eine Anschlusseinheit für einen Datenbus mit Schaltzustandserkennung ist beschrieben in EP 0 777 907 B1. Dort wird der Schaltzustand eines Lastkreises durch Magnetfeldsensoren überwacht und über einen Datenbus gemeldet. Zu diesem Zweck wird eine Differential-Hall-Effekt-Sonde eingesetzt. Ein Problem bei der Verwendung von Stromsensoren besteht darin, dass diese durch externe Magnetfelder oder auch Magnetfelder, die in der betreffenden Schaltung erzeugt werden, gestört werden. Außerdem benötigen Stromsensoren einen nicht unerheblichen Platz. Wenn mehrere solcher Sensoren vorhanden sind, müssen diese entsprechende Abstände haben, um sich nicht gegenseitig zu beeinflussen.

Ein Verfahren zur Strommessung in einem Schaltgerät mit Hilfe von Stromsensoren ist beschrieben in DE 102 53 018 A1. Hierbei sind Stromsensoren auf unterschiedlichen Seiten eines Strompfades angebracht. Die Signale der beiden Stromsensoren werden voneinander subtrahiert und das Differenzsignal wird als Messsignal zur Verfügung gestellt. Das Dokument DE 197 41 417 A1 offenbart eine Anschlusseinheit gemäß dem Oberbegriff des Anspruchs 1.

Der Erfindung liegt die Aufgabe zugrunde, eine Anschlusseinheit eines Bussystems mit Rückmeldung zur Ausführung eines Schaltbefehles zu schaffen, die kleinformatig und störunempfindlich ausgeführt werden kann.

Die erfindungsgemäße Anschlusseinheit ist durch den Anspruch 1 definiert. Nach der Erfindung weist die Versorgungsleitung, die das Schaltelement enthält, eine auf einer Leiterplatte angeordneten Leitungsabschnitt mit Hin- und Rückleitung zu dem Schaltorgan auf. Die Hinleitung und die Rückleitung enthalten jeweils eine Hauptleiterbahn, wobei mindestens eine Hauptleiterbahn einen quer zu der Hauptleiterbahn verlaufenden Messabschnitt enthält und Stromsensoren senkrecht zu der Leiterplatte auf den Messabschnitt gerichtet sind.

Ein magnetisch sensitiver Stromsensor ist typischerweise ein Hall-Sensor oder eine Feldplatte. Verwendet werden kann jede Art von Sensor, der anhand des durch einen Strom erzeugten Magnetfeldes ein Signal erzeugt, das die Stromstärke repräsentiert. Der Begriff "quer' ist so zu verstehen, dass der Messabschnitt unter einem von 0 verschiedenen Winkel zu der Hauptleiterbahn verläuft. Dieser Winkel sollte vorzugsweise im Bereich von 90° liegen, ist aber hierauf nicht beschränkt. Insbesondere sind Winkel zwischen 60° und 120° praktikabel. Der magnetisch sensitive Stromsensor ist mit der Flächennormalen seiner Messfläche auf den Messabschnitt gerichtet. Diese Flächennormale verläuft quer zu der Längsrichtung des Messabschnittes und vorzugsweise rechtwinklig dazu, wobei auch hier Winkel zwischen 60° und 120° praktikabel sind.

Bei der erfindungsgemäßen Anschlusseinheit ist die elektromagnetische Stromdetektierung kleinformatig auf einer Leiterplattenstruktur angeordnet, wobei die Hauptleiterbahnen relativ nahe beieinander liegen können, ohne sich störend zu beeinflussen. Würden die Hauptleiterbahnen parallel zueinander und geradlinig verlaufen, so würden sich bei zu naher gegenseitiger Anordnung die elektromagnetischen Felder überlagern und wegen der unterschiedlichen Stromrichtungen in Hin- und Rückleitung würden sich die Felder gegenseitig auslöschen oder zumindest stören. Durch den quer zu den Hauptleiterbahnen verlaufenden Messabschnitt wird ein derartiges Übersprechen vermieden, so dass die Leiterbahnen relativ nahe beieinander verlaufen können, wodurch eine platzsparende, kleinformatige Realisierung der magnetisch sensitiven Stromsensoren möglich ist.

Vorzugsweise haben die Hinleitung und die Rückleitung jeweils einen quer zu der betreffenden Hauptleiterbahn verlaufenden Messabschnitt und für jeden Messabschnitt ist ein Stromsensor vorgesehen. Die Stromsensoren können nebeneinander unter oder aber über der Leiterplattenebene angeordnet sein, in der sich die Leiterbahnen befinden. Die Messabschnitte benachbarter Hauptleiterbahnen sind vorzugsweise längs einer geraden Linie angeordnet, jedoch mit gegenseitigen Abständen.

Eine weitere Ausgestaltung der Erfindung sieht vor, dass eine die Ausgangssignale beider Stromsensoren mit unterschiedlichen Vorzeichen addierende Summiervorrichtung vorgesehen ist. Dadurch werden die Signale der beiden Messabschnitte, von denen einer zur Hinleitung und der andere zur Rückleitung gehört, addiert, während die Einflüsse externer Felder, die auf beide Stromsensoren mit gleicher Feldrichtung einwirken, sich gegenseitig auslöschen. Das Stromsensor-System ist damit unempfindlich gegen externe Störfelder.

Die grundsätzliche Anordnung und Gestaltung der Leiterbahnen hängt wesentlich von der Höhe des Stromes ab und lässt sich insbesondere durch die Verwendung mehrlagiger Platinen hinsichtlich der Leiterbahnfläche, der Leiterbahndicke und der Leiterbahnabstände optimieren. In unterschiedlichen Lagen einer Leiterplatte angeordnete und druchkontaktierte Leiterbahnen ermöglichen die Vergrößerung der Leiterbahnfläche und -dicke, so dass eine hinreichende Wärmeableitung und Strombelastung gewährleistet wird, ohne eine vorgegebene Leiterplattenfläche zu verändern. Die Wärmeableitung kann weiter verbessert werden, indem zusätzliche Flächen neben den stromführenden Bereichen der Leiterbahnen, vorzugsweise davon durch Schlitze getrennt, angeordnet werden. Da die Leiterbahnfläche durch diese Anordnung insgesamt vergrößert wird, auf der jeweiligen Lage aber wenig Fläche beansprucht, lassen sich Mindestabstände zwischen unterschiedlichen Stromkreisen leicht einhalten.

Mittels mehrlagiger Leiterbahnanordnungen lässt sich die Leiterplattenfläche somit vorteilhaft nutzen, wobei verschiedene Varianten realisierbar sind. Einerseits kann jede Lage mit jeweils einem separaten Stromkreis bestückt werden, andererseits können die Abstände zwischen den Leiterbahnen ausreichend groß gestaltet werden, so dass verschiedene Stromkreise auf der gleichen Lage angeordnet sind. In beiden Fällen sind die Wechselwirkungen zwischen den verschiedenen Stromkreisen minimiert.

Diejenige Leiterplatte, die die Hauptleiterbahnen trägt, trägt vorzugsweise auch das Schaltorgan, bei dem es sich um ein Relais oder einen Halbleiter, beispielsweise einen Schalttransistor oder ein Thyristor handeln kann. Die betreffende Leiterplatte kann als Starkstromplatine bezeichnet werden. Die Stromsensoren befinden sich auf einer Messplatine, die vorzugsweise senkrecht zu der Starkstromplatine angeordnet und an dieser fixiert ist. Die Leiterplattenstruktur kann eine dritte Leiterplatte aufweisen, die als Verarbeitungsplatine bezeichnet werden kann und den Mikroprozessor und andere Komponenten für die Signalverarbeitung trägt. Die Leiterbahnen der Leiterplatten sind in geeigneter Weise verbunden. Denkbar ist auch eine Anordnung aller Bauelemente auf einer speziell ausgebildeten Platine, wobei die Bauelemente und Stromkreise funktionell getrennt und störungssicher platziert sind.

Ein weiterer Vorteil der erfindungsgemäßen elektromagnetischen Stromdetektion besteht darin, dass keine Störaussendung auf andere Leitungen und Sensoren erfolgt, da die Messabschnitte nicht nebeneinander verlaufen. Die Messabschnitte kommen mit einer geringen Leiterbahnlänge aus, was zu einer Reduzierung der Wärmeentwicklung beiträgt. Durch die bevorzugte Unterbringung der Komponenten für Schaltorgan, Sensorik und Signalverarbeitung auf separaten Platinen werden elektrische oder magnetische Wechselwirkungen vermieden und die Funktionssicherheit wird erhöht. Schließlich werden durch Beschaltung von Eingang und Ausgang mit gegenläufig angeordneten Stromsensoren umweltbedingte Störeinflüsse eliminiert. Die elektromagnetische Strommessung kann sowohl bei Wechselstrom als auch bei Gleichstrom verwendet werden.

Bei geringstmöglichem Platzbedarf wird eine exakte Strommessung möglich.

Im Folgenden wird unter Bezugnahme auf die Zeichnungen ein bevorzugtes Ausführungsbeispiel der Erfindung näher erläutert.

Es zeigen:

Fig. 1    die Struktur eines Bussystems mit mehreren Anschlusseinheiten zur Steuerung von Verbrauchern,

Fig. 2    eine perspektivische Darstellung des mechanischen Aufbaus einer Anschlussvorrichtung,

Fig. 3    die Leiterplatten-Struktur nach Figur 2,

Fig. 4    einen Schnitt entlang der Linie IV-IV von Figur 3,

Fig. 5    eine Draufsicht auf die Starkstromplatine und

Fig. 6    eine schematische Darstellung der Anordnung der Stromsensoren von Hin- und Rückleitung mit einer Darstellung der Signalverarbeitung.

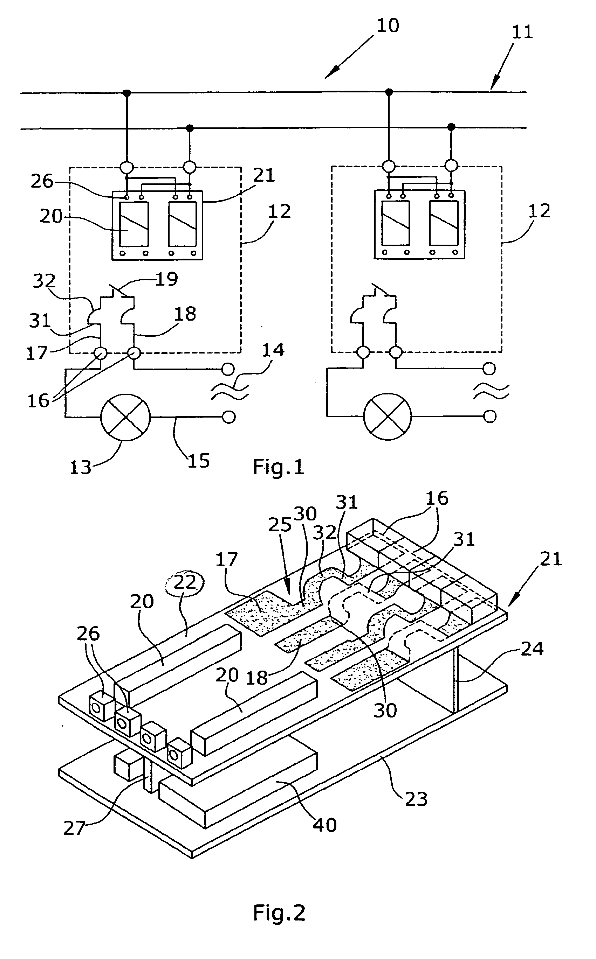

Figur 1 zeigt ein Bussystem 10 für die Gebäudesystemtechnik. Das Bussystem 10 weist einen in einem Gebäude installierten zweiadrigen Bus 11 auf, an den mehrere Anschlusseinheiten 12 angeschlossen sind, die verteilt in dem Gebäude installiert werden. Jede der Anschlusseinheiten 12 enthält einen Mikroprozessor. Die Anschlusseinheiten 12 sind mit unverwechselbaren Kennungen ausgestattet, so dass sie adressiert werden können. Die Anschlusseinheiten 12 können untereinander Datentelegramme austauschen. Die sendende Anschlusseinheit enthält beispielsweise einen Sensor oder einen Befehlsgeber für die manuelle/automatische Befehlseingabe. Diese Anschlusseinheit ist imstande, an eine ganz bestimmte Aktor-Anschlusseinheit 12 ein Datentelegramm zu senden, das u. a. einen Schaltbefehl enthalten kann. Die vorliegende Erfindung befasst sich nur mit der Ausgestaltung einer Aktor-Anschlusseinheit zur Ausführung von Befehlen.

Die Anschlusseinheit 12 dient zum Steuern eines externen Verbrauchers 13, der hier mit dem Symbol einer Lampe gekennzeichnet ist. Der Verbraucher 13 wird an eine Versorgungsstromquelle 14, beispielsweise das Versorgungsnetz mit 230 V Wechselspannung, angeschlossen, wobei die Versorgungsleitung 15 mit der Anschlusseinheit 12 verbunden ist. Zu diesem Zweck weist die Anschlusseinheit entsprechende Anschlussklemmen 16 auf. Von den Anschlussklemmen 16 führen eine Hinleitung 17 und eine Rückleitung 18 zu den beiden Polen eines in der Anschlusseinheit 12 vorgesehenen Schaltorgans 19, bei dem es sich hier um einen Relaiskontakt handelt. Das zugehörige Relais 20 befindet sich auf einer Leiterplattenstruktur 21. Das Relais 20 ist hier ein elektromagnetisches Relais, das entsprechend einem Aktor-Befehlssignal des Mikroprozessors erregt wird und das Schaltorgan 19 entsprechend betätigt.

Bei dem dargestellten Ausführungsbeispiel enthält jede Leiterplattenstruktur 21 zwei Relais 20, so dass zwei Verbraucher unabhängig voneinander von einer Anschlusseinheit 12 gesteuert werden können.

Figur 2 zeigt den mechanischen Aufbau der Leiterplattenstruktur 21. Diese weist eine obere erste Leiterplatte 22 und eine untere zweite Leiterplatte 23 sowie eine dazwischen angeordnete dritte Leiterplatte 24 auf. Die Leiterplatten 22, 23 verlaufen parallel zueinander und zwischen ihnen erstreckt sich rechtwinklig die dritte Leiterplatte 24, so dass alle drei Leiterplatten eine H-förmige Struktur bilden. Die Leiterplatten 22 und 23 können an dem in Figur 2 linken Ende durch eine zur Leiterplatte 24 parallele Stütze 27 abgestützt sein.

Die Hin- und Rückleitungen 17, 18 bilden auf der Leiterplatte 22 einen breiten Leitungsabschnitt 25. Die erste Leiterplatte 22 trägt ferner zwei Anschlussklemmen 16 zum Anschluss des externen Verbrauchers 13 an den Leitungsabschnitt 25. Außerdem trägt sie zwei weitere Anschlussklemmen 26 für den Anschluss an die Busleitungen 11. Auf der Leiterplatte 22 befinden sich auch die beiden Relais 20, deren Relaiskontakte in Figur 2 nicht dargestellt sind.

Die Hinleitung 17 und die Rückleitung 18 bestehen jeweils aus einer Hauptleiterbahn 30, die in Längsrichtung der Leiterplatte 22 verläuft, und einem hierzu quer verlaufenden Messabschnitt 31. Wie aus Figur 2 hervorgeht, sind die Messabschnitte 31 entlang einer Linie in gegenseitiger Verlängerung angeordnet, ohne sich zu berühren. Die Hauptleiterbahn 30 weist einen bogenförmigen Abschnitt 32 auf, der mit dem äußeren Ende des Messabschnittes 31 verbunden ist. Die Hauptleiterbahn 30 ist somit im wesentlichen geradlinig, wobei lediglich die in ihrem Verlaufe angeordneten Abschnitte, nämlich der bogenförmige Abschnitt 32 und der Messabschnitt 31, aus der geraden Linie seitlich herausragen.

Die Hauptleiterbahn 30 ist wesentlich breiter als der Messabschnitt 31. Je größer die Leiterbahnfläche ist, desto geringer ist die Hitzeentwicklung. Eine Alternative der Leiterbahngestaltung liegt darin, an Stelle einer Hauptleiterbahn 30 mehrere Leiterbahnen anzuordnen, die in unterschiedlichen Ebenen der Leiterplatte verlaufen und mehrfach durchkontaktiert sind. Dadurch lässt sich die Gesamtfläche der Leiterbahnen sowohl für den Strom führenden als auch für den Wärme ableitenden Bereich vergrößern, wobei jede einzelne Leiterbahn relativ schmal ist, so dass die Leiterbahnen mit größerem Abstand störungsfrei nebeneinander verlaufen können.

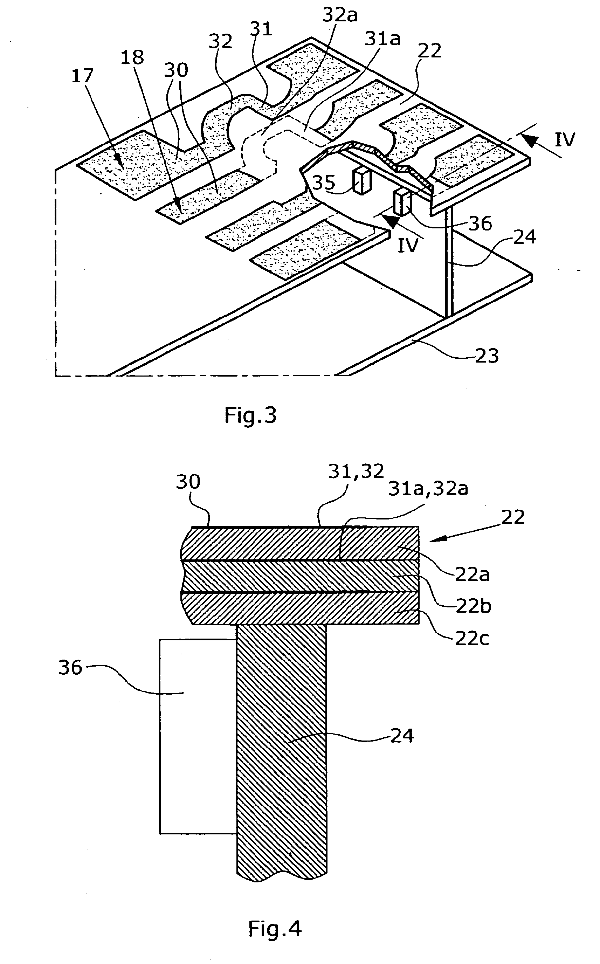

Die bogenförmigen Abschnitte 32 und die Messabschnitte 31 zweier benachbarter Hauptleiterbahnen 30 liegen in unterschiedlichen Ebenen, wie sich aus Figur 4 ergibt. Die Hauptleiterbahnen 30 befinden sich auf der Oberseite der Leiterplatte 22. Der Messabschnitt 31 und der bogenförmige Abschnitt 32 der Hinleitung 17 sind ebenfalls auf der Oberseite der Leiterplatte 22 angeordnet. Der Messabschnitt 31a und der bogenförmige Abschnitt 32a der Rückleitung 18 befinden sich dagegen im Innern der Leiterplatte 22 (Figur 4), die aus mehreren Schichten besteht. Die Leiterplatte 22 ist eine Mehrschichtplatte mit einer oberen Schicht 22a, einer mittleren Schicht 22b und einer unteren Schicht 22c. Zwischen den Schichten befinden sich Leiterbahnen, wie Figur 4 zeigt. Die Leiterbahnen der verschiedenen Ebenen sind teilweise durch Durchkontaktierung miteinander verbunden.

Die zweite Leiterplatte 24 stößt in der Nähe der Messabschnitte 31, 31a gegen die obere Leiterplatte 22, wie Figur 3 zeigt. An der zweiten Leiterplatte 24 befinden sich Stromsensoren 35, 36, die unterhalb der jeweiligen Messabschnitte 31 bzw. 31a angeordnet sind. Ein von dem Messabschnitt erzeugtes Magnetfeld wird von dem betreffenden Stromsensor 35, 36 detektiert. Das Signal des Stromsensor wird auf der Leiterplatte 24 verarbeitet.

Die untere Leiterplatte 23 trägt neben anderen Komponenten einen Mikroprozessor 40, der das Signal der Anschlussklemmen 26 verarbeitet und daraus das Aktor-Befehlssignal für die Relais 20 erzeugt. Die Leiterbahnen der Leiterplatten 23 und 24 sind aus Gründen der Übersichtlichkeit hier nicht dargestellt.

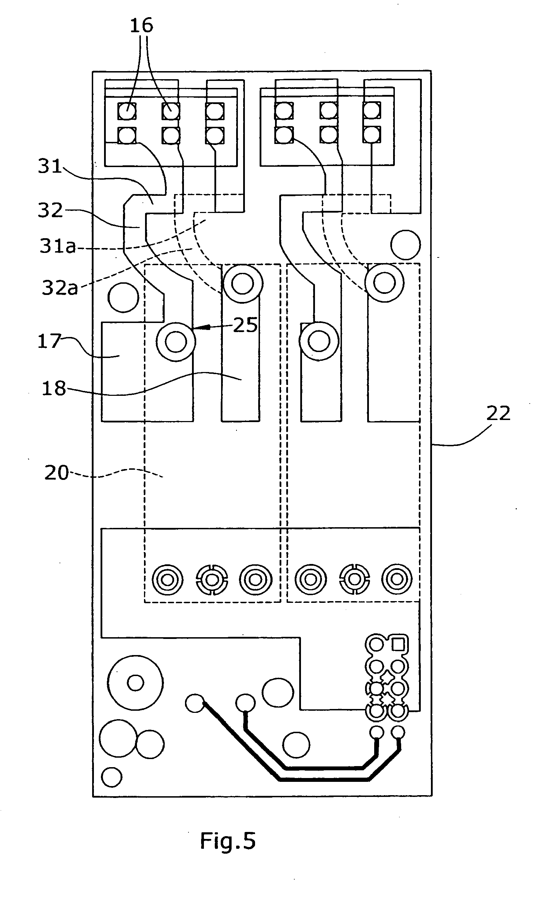

Figur 5 zeigt in größerem Detail den Aufbau der ersten Leiterplatte 22, die hier unbestückt dargestellt ist, wobei die Position der Relais 20 gestrichelt angedeutet ist. Man erkennt, dass die Hauptleiterbahn 30 der Hinleitung 17 auf der Oberseite der Leiterplatte angeordnet ist, während die Rückleitung 18 die in der Ebene versetzten Abschnitte, nämlich den Messabschnitt 31a und den bogenförmigen Abschnitt 32a, enthält.

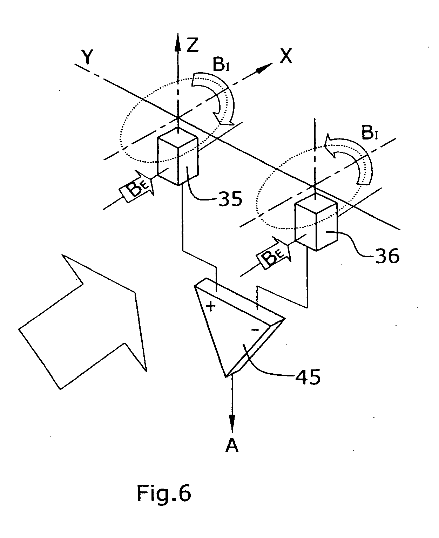

Figur 6 zeigt die beiden Stromsensoren 35, 36 durch die die Z-Achse in Längsrichtung hindurch geht. Die Y-Achse verläuft in Längsrichtung der Messabschnitte 31 bzw. 31a. Die X-Achse verläuft in Längsrichtung der Hauptleiterbahn.

Ein Stromfluss durch den Messabschnitt erzeugt in dem Stromsensor 35 ein ringförmiges Magnetfeld $B_1$, in der XZ-Ebene um den Messabschnitt 31 herum. In dem Messabschnitt 31a der Rückleitung wird ebenfalls ein Magnetfeld $B_I$ erzeugt, das auf den Stromsensor 36 einwirkt, jedoch dem Magnetfeld $B_I$ des Messabschnitt 31 entgegengesetzt gerichtet ist. Die Ausgänge der beiden Stromsensoren 35, 36 werden einem Operationsverstärker 45 zugeführt, dessen beide Eingänge unterschiedliche Vorzeichen haben. Der Operationsverstärker 45 bewirkt daher, dass die Signale der Magnetfelder $B_I$, die unterschiedlich gerichtet sind, voneinander subtrahiert werden, was dazu führt, dass die Beträge der beiden Signale addiert werden. Der Operationsverstärker bildet daher eine Summiereinrichtung.

Im Falle eines externen Störfeldes $B_E$ wirkt dieses Störfeld auf beide Stromsensoren 35, 36 aus gleicher Richtung ein. Die Signalanteile, die von dem externen Magnetfeld erzeugt werden, werden im Operationsverstärker 45 subtrahiert und kompensieren sich. Das Ausgangssignal A des Operationsverstärkers 45 ergibt sich somit zu

$$A = (B_E + B_I) - (B_E - B_I) = 2 \times B_I.$$

Man erkennt, dass die Einflüsse des externen Magnetfeldes eliminiert werden, während die Einflüsse der internen Magnetfelder, die von den Messabschnitten 31, 31a erzeugt werden, summiert werden.

**Patentansprüche**

1. Anschlusseinheit eines Bussystems (10), mit einem Mikroprozessor (40) zur Erzeugung eines Aktor-Befehlssignals, einem durch das Aktor-Befehlssignal gesteuerten Schaltorgan (19) zum Schalten einer eine Last (13) enthaltenden Versorgungsleitung (15), einer Leiterplatte (22) und einem magnetisch sensitiven Stromsensor (35, 36) zur Detektierung bzw. Messung des Stromes in der Versorgungsleitung (15),
   **dadurch gekennzeichnet,**
   **dass** die Versorgungsleitung (15) einen auf der Leiterplatte (22) angeordneten Leitungsabschnitt mit Hin- und Rückleitung (17, 18) zu dem Schaltorgan (19) aufweist, und
   **dass** die Hinleitung (17) und die Rückleitung (18) jeweils eine Hauptleiterbahn (30) aufweist, wobei jede Hauptleiterbahn (30) einen quer zu der betreffenden Hauptleiterbahn (30) verlaufenden Messabschnitt (31, 31 a) enthält und für jeden Messabschnitt ein Stromsensor (35, 36) vorgesehen ist, der auf den jeweiligen Messabschnitt (31, 31a) der Leiterplatte (22) gerichtet ist.

2. Anschlusseinheit nach Anspruch 1, **dadurch gekennzeichnet, dass** eine die Ausgangssignale beider Stromsensoren (35, 36) mit unterschiedlichen Vorzeichen addierende Summiervorrichtung (45) vorgesehen ist.

3. Anschlusseinheit nach Anspruch 1 oder 2, **dadurch gekennzeichnet, dass** die Messabschnitte (31, 31a) in unterschiedlichen Ebenen der Leiterplatte (22) angeordnet sind.

4. Anschlusseinheit nach einem der Ansprüche 1 - 3, **dadurch gekennzeichnet, dass** der mindestens eine Stromsensor (35, 36) an einer senkrecht zu der ersten Leiterplatte (22) verlaufenden Hilfsleiterplatte (24) angeordnet ist.

5. Anschlusseinheit nach Anspruch 4, **dadurch gekennzeichnet, dass** parallel zu der ersten Leiterplatte (22) eine zweite Leiterplatte (23) verläuft, wobei beide Leiterplatten durch die Hilfsleiterplatte (24) verbunden sind.

6. Anschlusseinheit nach Anspruch 5, **dadurch gekennzeichnet, dass** die zweite Leiterplatte (23) unter anderem den Mikroprozessor (40) trägt.

7. Anschlusseinheit nach einem der Ansprüche 1 - 6, **dadurch gekennzeichnet, dass** der Messabschnitt (31, 31 a) schmaler ist als die Hauptleiterbahn (30).

8. Anschlusseinheit nach einem der Ansprüche 1 - 7, **dadurch gekennzeichnet, dass** separate Leiterplatten (22-24) für das Schaltorgan (19), den Stromsensor (35, 36) und die Signalverarbeitung vorgesehen sind.

9. Anschlusseinheit nach einem der Ansprüche 1 - 8, **dadurch gekennzeichnet, dass** die Leiterbahnen auf der Leiterplatte (22) mehrlagig aufgebaut sind.

10. Anschlusseinheit nach einem der Ansprüche 1 - 9, **dadurch gekennzeichnet, dass** der Messabschnitt eine geringere Breite hat als die übrigen Bereiche der Leiterbahnen.

**Claims**

1. Connection unit of a bus system (10), having a microprocessor (40) for generating an actuator command signal, a switching member (19) which is controlled by the actuator command signal and is intended to switch a supply line (15) containing a load (13), a printed circuit board (22) and a magnetically sensitive current sensor (35, 36) for detecting and/or measuring the current in the supply line (15),
   **characterized in that**
   the supply line (15) has a line section which is arranged on the printed circuit board (22) and has a forward line (17) and a return line (18) to the switching member (19), and
   **in that** the forward line (17) and the return line (18) each have a main conductor track (30), each main conductor track (30) containing a measuring section (31, 31a) which runs transversely with respect to the relevant main conductor track (30), and a current sensor (35, 36) being provided for each measuring section and being directed towards the respective measuring section (31, 31a) of the printed circuit board (22).

2. Connection unit according to Claim 1, **characterized in that** a summing device (45) which adds the output signals from the two current sensors (35, 36) with different signs is provided.

3. Connection unit according to Claim 1 or 2, **characterized in that** the measuring sections (31, 31a) are arranged in different planes of the printed circuit board (22).

4. Connection unit according to one of Claims 1-3, **characterized in that** the at least one current sensor (35, 36) is arranged on an auxiliary printed circuit board (24) which runs perpendicular to the first printed circuit board (22).

5. Connection unit according to Claim 4, **characterized in that** a second printed circuit board (23) runs parallel to the first printed circuit board (22), the two printed circuit boards being connected by the auxiliary printed circuit board (24).

6. Connection unit according to Claim 5, **characterized in that** the second printed circuit board (23) carries the microprocessor (40), inter alia.

7. Connection unit according to one of Claims 1-6, **characterized in that** the measuring section (31, 31a) is narrower than the main conductor track (30).

8. Connection unit according to one of Claims 1-7, **characterized in that** separate printed circuit boards (22-24) are provided for the switching member (19), the current sensor (35, 36) and the signal processing.

9. Connection unit according to one of Claims 1-8, **characterized in that** the conductor tracks on the printed circuit board (22) are of multilayer construction.

10. Connection unit according to one of Claims 1-9, **characterized in that** the measuring section has a narrower width than the remaining regions of the conductor tracks.

**Revendications**

1. Unité de raccordement d'un système de bus (10), comprenant un microprocesseur (40) pour générer un signal de commande d'actionneur, un organe de commutation (19) commandé par le signal de commande d'actionneur pour commuter une ligne d'alimentation (15) contenant une charge (13), un circuit imprimé (22) et un détecteur de courant (35, 36) magnétosensitif pour détecter ou mesurer le courant dans la ligne d'alimentation (15), **caractérisée en ce que** la ligne d'alimentation (15) présente une section de ligne disposée sur le circuit imprimé (22) avec une ligne d'aller et de retour (17, 18) vers l'organe de commutation (19) et **que** la ligne d'aller (17) et la ligne de retour (18) présentent respectivement une piste conductrice principale (30), chaque piste conductrice principale (30) contenant une section de mesure (31, 31a) qui s'étend transversalement par rapport à la piste conductrice principale (30) concernée et un détecteur de courant (35, 36) étant prévu pour chaque section de mesure, lequel est dirigé sur la section de mesure (31, 31a) correspondante du circuit imprimé (22).

2. Unité de raccordement selon la revendication 1, **caractérisée en ce qu'**il est prévu un dispositif additionneur (45) qui additionne les signaux de sortie des deux détecteurs de courant (35, 36) avec des signes différents.

3. Unité de raccordement selon la revendication 1 ou 2, **caractérisée en ce que** les sections de mesure (31, 31a) sont disposées dans des plans différents sur le circuit imprimé (22).

4. Unité de raccordement selon l'une des revendications 1 à 3, **caractérisée en ce que** l'au moins un détecteur de courant (35, 36) est disposé sur un circuit imprimé auxiliaire (24) qui s'étend perpendiculairement au premier circuit imprimé (22).

5. Unité de raccordement selon la revendication 4, **caractérisée en ce qu'**un deuxième circuit imprimé (23) s'étend parallèlement au premier circuit imprimé (22), les deux circuits imprimés étant reliés par le circuit imprimé auxiliaire (24).

6. Unité de raccordement selon la revendication 5, **caractérisée en ce que** le deuxième circuit imprimé (23) comporte entre autres le microprocesseur (40).

7. Unité de raccordement selon l'une des revendications 1 à 6, **caractérisée en ce que** la section de mesure (31, 31a) est plus étroite que la piste conductrice principale (30).

8. Unité de raccordement selon l'une des revendications 1 à 7, **caractérisée en ce que** des circuits imprimés (22-24) séparés sont prévus pour l'organe de commutation (19), le détecteur de courant (35, 36) et le traitement de signal.

9. Unité de raccordement selon l'une des revendications 1 à 8, **caractérisée en ce que** les pistes conductrices sont constituées de plusieurs couches sur le circuit imprimé (22).

10. Unité de raccordement selon l'une des revendications 1 à 9, **caractérisée en ce que** la section de mesure possède une largeur inférieure à celle des

**EP 2 057 658 B1**

autres zones des pistes conductrices.

Fig.1

Fig.2

Fig.3

Fig.4

Fig.5

Fig.6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0777907 B1
- DE 10253018 A1
- DE 19741417 A1